# EUROPEAN PATENT APPLICATION

(11) **EP 0 620 594 A2**
(43) Date of publication of application: **19.10.1994**
(21) Application number: 94302551.0
(22) Date of filing: 12.04.1994
(51) Int. Cl.: H01L 23/498, H01L 23/057

(54) **Semiconductor device having mounting terminals**

(30) Priority: 13.04.1993 JP 86096/93; 14.09.1993 JP 227715/93
(71) Applicant: SHINKO ELECTRIC INDUSTRIES CO. LTD., Nagano-shi, Nagano 380 (JP)
(72) Inventor: Tanaka, Masato, c/o SHINKO ELECTRIC IND. CO. LTD., Nagano-shi, Nagano 380 (JP); Higashi, Mitsutoshi, c/o SHINKO ELEC. IND. CO.LTD, Nagano-shi, Nagano 380 (JP); Takahashi, Iwao, c/o SHINKO ELECTRIC IND. CO. LTD., Nagano-shi, Nagano 380 (JP); Miyasaka, Toshiji, c/o SHINKO ELECTRIC IND. CO.LTD, Nagano-shi, Nagano 380 (JP)
(74) Representative: Rackham, Stephen Neil

(57) **Abstract**

A semiconductor device includes: a plate like device substrate (12) having upper and lower surfaces and a semiconductor chip (14) rigidly mounted on one of them. Circuit patterns (16) are formed on the one surface, each circuit pattern having one end electrically connected to the semiconductor chip (14) and the other end formed as a land portion (20) for electrical connection to an outside circuit. A plate like terminal substrate (26) has upper and lower surfaces and a plurality of through holes (30) and a plurality of mounting terminals (32) inserted into and fixed to the through holes (30). The mounting terminal (32) projects from the upper and lower surfaces of the terminal substrate, respectively. The terminal substrate (26) is attached to the device substrate (12), so that upper contacts (34) on the terminal substrate are electrically connected to the land portions (20) on the device substrate (12).

## Description

The present invention relates to a semiconductor device, and particularly to a semiconductor device that employs mounting terminals.

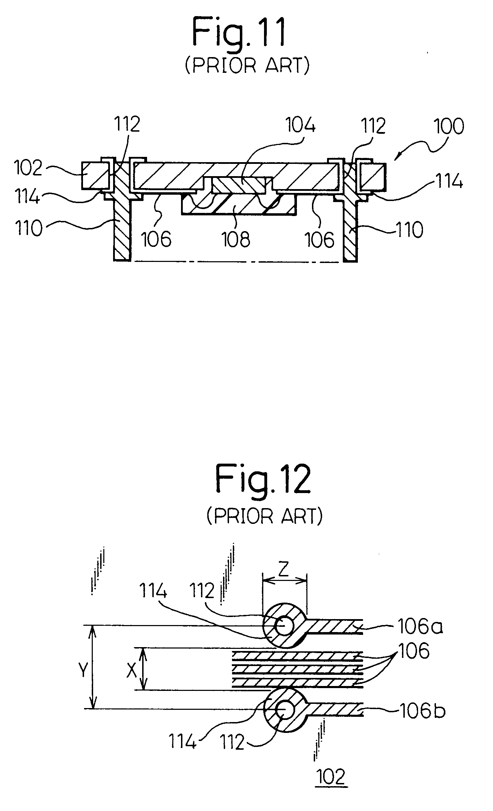

A semiconductor device employing mounting terminals has been conventionally known in the prior art, as shown in Figs. 11 and 12. Fig. 11 is a cross-sectional view of a semiconductor device (for example, pin-grid array type semiconductor device) employing mounting terminals known in the prior art. Fig. 12 is a partial bottom view of the semiconductor device shown in Fig. 11.

The semiconductor device of Fig. 11 comprises a base resin substrate 102 and a semiconductor chip 104 rigidly mounted on the lower surface thereof. The semiconductor chip 104 is connected by means of wires to a plurality of circuit patterns 106 formed around the chip 104 and on the lower surface of the substrate 102.

The semiconductor chip 104 and the connecting portions between the chip 104 and the circuit patterns 106 are integrally, hermetically sealed with a resin 108. Mounting terminals 110 are inserted into a plurality of through holes 112 which are arranged on the substrate 102 at the peripheral area thereof. As shown in Fig. 12, the through hole 112 is opened at at the center of land portion 114. An inner surface of the through hole 112 is plated with a metal to which the mounting terminal 110 is soldered.

The mounting terminals 110 are connected to a circuit board (not shown) and thus the semiconductor device 100 can be surface-mounted thereon.

The above-mentioned semiconductor device 100 has the following problems.

Since it is necessary that the inner surface of the through hole 112 is metal-plated to secure the mounting terminals 110 to the substrate 102 so as to electrically connect to the circuit patterns 106. Thus a manufacturing cost is raised because of necessity of such a metal plating process.

In addition, since the through hole 112 is positioned at the centre of the land portion 114, the diameter Z of the land portion 114 must be larger than the diameter of through hole 112. According to the recent requirement for high density of circuit patterns 106, for example, as shown in Fig. 12, if other circuit patterns 106 are arranged between two circuit patterns 106a and 106b (the distance therebetween being Y), the possible area X for the other circuit patterns 106 will be X = Y - Z. Therefore, if the diameter Z of the land portion 114 becomes larger, it will be difficult to attain a high density of circuit patterns 106. On the other hand, since the through hole 112 must be arranged at the centre of the land portion 114, it is difficult to reduce the diameter of the land portion 114. Thus, in the semiconductor device having mounting terminals, it is difficult to further attain a high density of the circuit patterns 106.

According to the present invention a semiconductor device comprises:
a plate like device substrate having first and second surfaces;
a semiconductor chip rigidly mounted on said first surface of said device substrate;
circuit patterns formed on at least one of said first and second surfaces of said device substrate, each of said circuit patterns having one end which is electrically connected to said semiconductor chip and the other end formed as a land portion for electrically connecting to an outside circuit;
a moulded resin hermetically sealing said semi-conductor chip and said each one end of said circuit patterns;
a plate like terminal substrate having first and second surfaces and a plurality of through holes extending from said first surface to the second surface;
a plurality of mounting terminals inserted into and fixed to said respective through holes, each of said mounting terminals having first and second contacts projecting from said first and second surfaces of said terminal substrate, respectively; and,
said terminal substrate being attached to said device substrate, so that said first contacts of said terminal substrate are electrically connected to said land portions of said circuit patterns of said device substrate.

As mentioned above, according to the present invention, said terminal substrate is attached to said device substrate, so that said first contacts of said terminal substrate are electrically connected to said land portions of said circuit patterns of said device substrate. Thus, it is no longer necessary to provide through holes at the respective land portions of the circuit patterns to electrically connect the land portions to the mounting terminals. Therefore, a high density of the circuit patterns can be attained, since the necessity for metal plating the through holes is eliminated.

Preferred embodiments of semiconductor devices in accordance with this invention will now be described and contrasted with the prior art with reference to the accompanying drawings, in which:-
Figures 1, 2 and 3 are cross sectional views showing some semiconductor devices to which the present invention can be applied;
Figures 4A and 4B are partial cross sectional views of the semiconductor device showing embodiments of a portion for securing a mounting terminal to a mounting substrate;
Figure 5 is a cross sectional view showing another embodiment of a portion for securing a mounting terminal to a mounting substrate;
Figures 6A and 6B are partial cross sectional views of still other embodiments of a portion for securing a mounting terminal to a mounting substrate;
Figure 7 is a cross sectional view showing still another embodiment of a portion for securing a mounting terminal to a mounting substrate;
Figure 8 is a cross sectional view showing an embodiment of a connection of a mounting carrier to a semiconductor device;
Figure 9 is a cross sectional view showing another embodiment of a connection of a mounting carrier to a semiconductor device;
Figure 10 is a cross sectional view showing still another embodiment of a connection of a mounting carrier to a semiconductor device;
Figure 11 is a sectional view showing a semiconductor device according to a prior art; and
Figure. 12 is a partial bottom view of the semiconductor device of Fig. 11 and shows circuit patterns and land portions.

In the embodiments, a pin-grid array type semiconductor device will be described as a semiconductor device having mounting terminals.

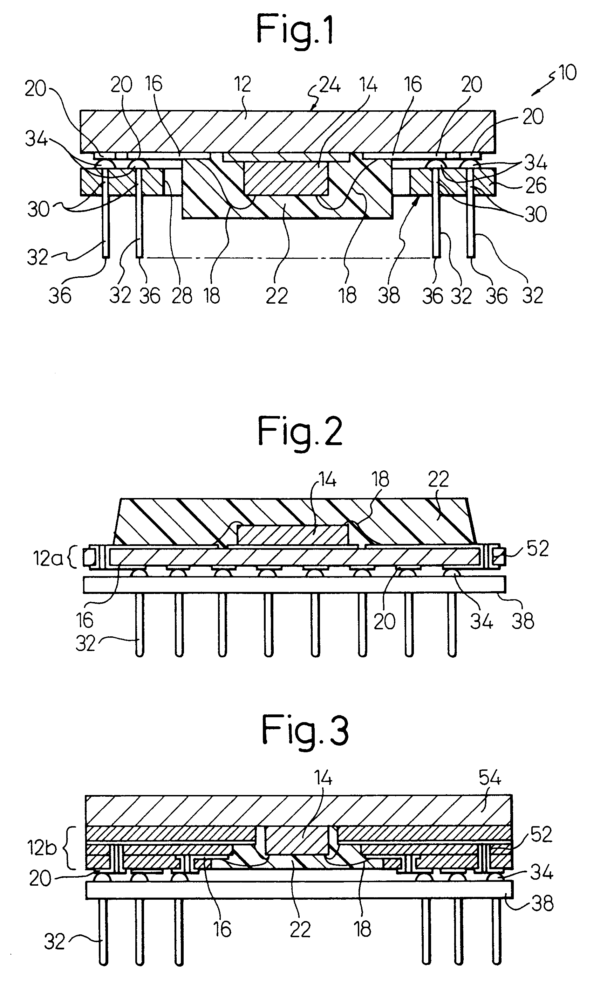

In Figs. 1, 2 and 3, a semiconductor device employing mounting terminals according to the present invention comprises a device substrate 12 which is made of a rectangular plate-shaped insulation material, such as a synthetic resin (for example, glass-epoxy resin). A semiconductor chip 14, i.e., a chip formed as integrated circuit (IC), is rigidly mounted on the lower surface of the device substrate 12.

A plurality of circuit patterns 16 are formed on the lower surface of the device substrate 12 and around the semiconductor chip 14. Such circuit patterns 16 can be formed be etching a copper foil on the device substrate 12, as well known in the art. The inner ends of the respective circuit patterns 16, ends thereof adjacent to the semiconductor chip 14, are electrically connected to the semiconductor chip 14 by means of bonding wires 18. On the other hand, the outer ends of respective circuit patterns 16 are electrically connected to circular-shaped land portions 20, which are contacts with mounting terminals, as will be mentioned later.

A molded resin 22 is protruded downward from the lower surface of the device substrate 12 for integrally and hermetically sealing the semiconductor chip 14, the inner ends of the circuit patterns 16 and others. Thus, the semiconductor device can be formed by the above-mentioned device substrate 12, the semiconductor chip 14, the circuit patterns 16 and others.

A terminal substrate 26 is also made of a rectangular plate-shaped insulation material, such as a synthetic resin (for example, glass-epoxy resin). The terminal substrate 26 is substantially the same as the device substrate 12 in size, dimension and in outer appearance, except for a central opening 18 provided at the center of the terminal substrate 26. Such a central opening 18 has a size to sufficiently receive the mold resin 22. The terminal substrate 26 is provided with a plurality of through holes 30 at positions corresponding to the land portions 20.

Mounting terminals 32 are made of metal pins and are inserted downward into the respective through holes 30 from the upper surface of the terminal substrate 26. The upper end 34 of each mounting terminal 32 is formed as a bump as a first contact and protrudes upward from the upper surface of the terminal substrate 26. The upper end 34 of the mounting terminal 32 can be seen as a circular-shaped configuration, the diameter of which is less than the diameter of the land portion 20. On the other hand, the lower end 36 of the the mounting terminal 32 protrudes downward from the lower surface of the terminal substrate 26 and extending downward over the lower surface of the mold resin 22. At least the lower end 36 of the the mounting terminal 32 is formed in a suitable size, so as to make it possible to mount the same on a circuit substrate (not shown).

The above-mentioned terminal substrate 26 and the mounting terminals 32 constitute a mounting carrier 38.

The semiconductor device employing mounting terminals according to the present invention can be completed as follows. The lower surface of the device substrate 12 constituting a semiconductor device 24 is arranged so as to correspond to the upper surface of the terminal substrate 26 constituting the above-mentioned mounting carrier 38. The upper ends 34 of the respective mounting terminals 32 are electrically connected to the respective land portions 20 of the circuit patterns 16, as shown in Fig. 1, and then the semiconductor device 24 is connected to the mounting carrier 38 by suitable means, as mentioned later.

In the semiconductor device 10 employing mounting terminals, the lower ends 36 of the mounting terminals 32 are connected to and mounted on a circuit substrate (not shown) by a so-called surface mounting process.

As clearly understood from the above, the present invention can be applied to various kinds of semiconductor devices or packages, such as a single layer semiconductor package having a semiconductor chip 14 mounted on the lower surface of the package 12, as shown in Fig. 1. In this case, the lower ends 36 of the mounting terminals 32 extend downward beyond the bottom surface of the molded resin 22.

On the other hand, in Fig. 2, a semiconductor chip 14 is mounted on the upper surface of the package 12a and circuit patterns 16 extend from the upper surface to the lower surface of the package via through holes 52. In this case, a full grid type can be attained. That is to say, the land portions 20 of the circuit patterns 16 and the upper contacts 34 of the mounting terminals 32 can be arranged in the whole area of the package 12a and terminal substrate 38, respectively.

In Fig. 3, a semiconductor chip 14 is mounted on the lower surface of a heat radiation plate 54, made of copper or aluminum, and arranged within an opening of a multi-layer substrate 12b. In this case, the circuit patterns 16 extend from bonding areas, which are electrically connected to the semiconductor chip 14 by means of bonding wires 18, to the lower surface of the multi-layer substrate 12b via through holes 52.

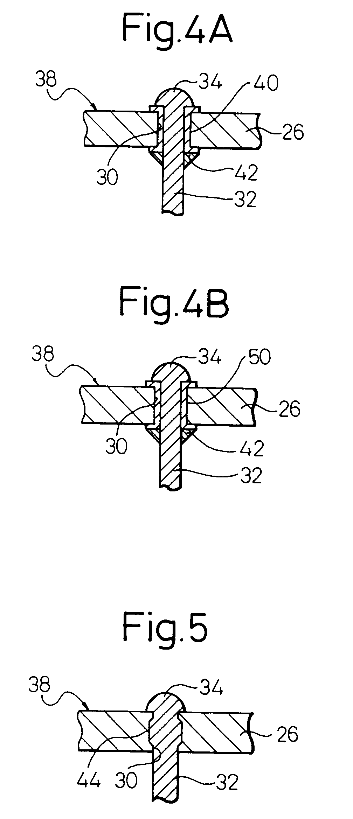

Some methods for securing the mounting terminals 32 to the terminal substrate will now be described with reference to Figs. 4A, 4B, 5, 6A, 6B and 7.

In the embodiment shown in Fig. 4A, the mounting terminal 32 has a head portion 34 thereof. A metal sleeve 40 is inserted into each of the through holes 30 of the terminal substrate 26 and the mounting terminal 32 is also inserted into the respective sleeve 40. The mounting terminal 32 is rigidly secured to the sleeve 40 by a solder 42. Therefore, the surfaces of both the mounting terminal 32 and the sleeve 40 are treated by a plating in advance to improve the wetting by solder.

Fig. 4B shows a modified embodiment of Fig. 4A. The inner wall and the open end periphery of the through holes 30 of the terminal substrate 26 is plated with a metal, such as copper, to form a plated layer 50. The mounting terminal 32 is inserted into the through hole formed with the plated layer 50. The mounting terminal 32 is rigidly secured to the through hole 30 by a solder 42. In the same manner as the above, the surface of the mounting terminal 32 is treated by a plating in advance to improve the wetting by solder.

In the embodiment shown in Fig. 5, the mounting terminal 32 is provided at the intermediate position thereof with a thick portion 44, where the diameter thereof is increased. The mounting terminal 32 with a thick portion 44 is forcedly inserted into the through hole 30 and fixed thereto.

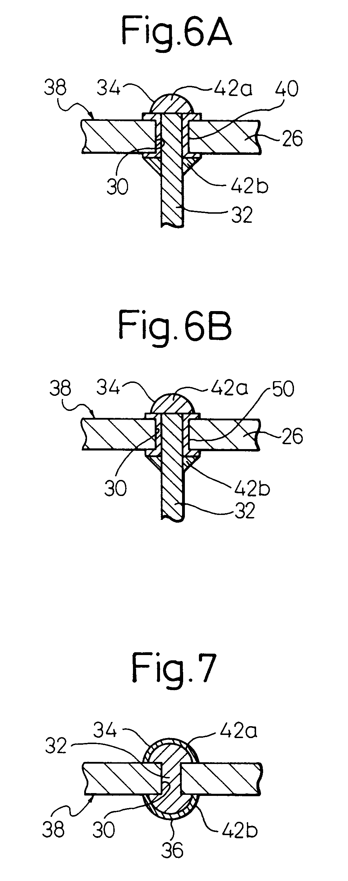

In the embodiment shown in Fig. 6A, the mounting terminal 32 has a cylindrical rod. A metal sleeve 40 is inserted into each of the through holes 30 of the terminal substrate 26 and the mounting terminal 32 is also inserted into the respective sleeve 40, so that the upper end of the mounting terminal 32 is located within the sleeve 40. A first contact is formed by bump-like solder 42a which electrically connects the upper end of the sleeve 40 to the upper end of the mounting terminal 32. To more stably connect the sleeve 40 and the mounting terminal 32 to each other, the lower end of the sleeve 40 is also rigidly connected to an intermediate portion of the mounting terminal 32 by solder 42b. In the same manner as the above-mentioned embodiments, the surfaces of both the mounting terminal 32 and the sleeve 40 are treated by a plating in advance to improve the wetting by solder.

Fig. 6B shows a modified embodiment of Fig. 6A. In the same manner as the embodiment shown in Fig. 4B, the inner wall and the open end periphery of the through holes 30 of the terminal substrate 26 is plated with a metal, such as copper, to form a plated layer 50. On the other hand, the mounting terminal 32 is a cylindrical rod in the same manner as the embodiment shown in Fig. 6A, and the mounting terminal 32 is inserted into the through hole 30 formed with the plated layer 50, so that the upper end of the mounting terminal 32 is located within the through hole 30. A first contact is formed by bump-like solder 42a which electrically connects the upper end of the plated layer 50 to the upper end of the mounting terminal 32. To more stably connect the plated layer 50 and the mounting terminal 32 to each other, the lower end of plated layer 50 is also rigidly connected to an intermediate portion of the mounting terminal 32 by solder 42b. In the same manner as the above, the surface of the mounting terminal 32 is treated by a plating in advance to improve the wetting by solder.

In the embodiment shown in Fig. 7, the mounting terminal 32 is not pin-shaped, but has bump-like first contact 34 and second contact 36 projecting upward and downward, respectively, from the upper and lower surfaces of the terminal substrate 26. This mounting terminal 32 is plated with a copper and also covered with solders 42a and 42b. If the terminal substrate 26 is relatively thin, such a mounting terminal 32 having bump-like first and second contacts 34 and 36 can be formed by plating the through hole 30 with a metal, such as copper, and enlarging the plated metal to project upward and downward, respectively, from the upper and lower surfaces of the terminal substrate 26.

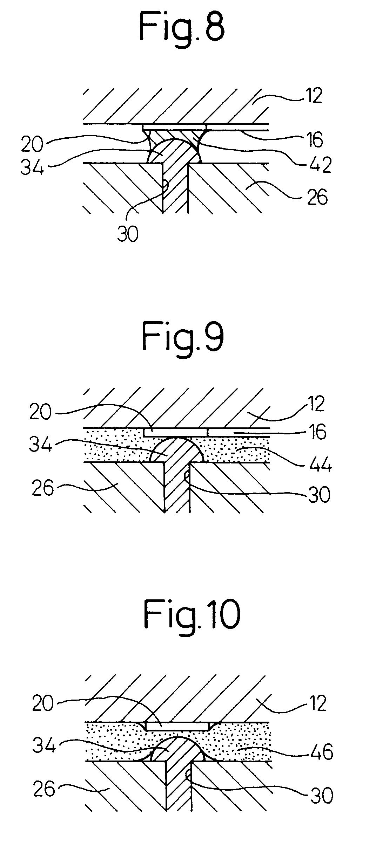

Some methods for connecting the semiconductor device 24 to the mounting carrier 38 will now be described with reference to Figs. 8, 9 and 10.

In the embodiment shown in Fig. 8, the upper end of the mounting terminal 32 is connected to the land portion 20 of the device substrate 12 by solder 42, so that the semiconductor device 24 can be electrically connected to the mounting carrier 38. In the case of the embodiments of Figs. 6A and 6B, the head portion (i.e., solder 42a) itself can be used to solder to the land portion 20. Of course, the other solder 42 can be used or added to be soldered. In this case, the connecting portion can more easily be controlled. Solder (not shown) can also be provided on the land portions 20 by any known printing method.

In the embodiment shown in Fig. 9, the upper end of the mounting terminal 32 is in mechanical contact with the land portion 20 of the device substrate 12, so that the semiconductor device 24 is electrically connected to the mounting carrier 38. Then, an adhesive agent 44 is introduced into the gap between the device substrate 12 and the terminal substrate 26 to rigidly connect therebetween. Such an adhesive agent 44 may be a film-like adhesion. In this case, the film-like adhesion 44 is disposed between the device substrate 12 and the terminal substrate 26 and any suitable heat and pressure are applied therebetween.

In the embodiment shown in Fig. 10, an anisotropic conductive film 46 is disposed between the device substrate 12 and the terminal substrate 26, so that the upper end of the mounting terminal 32 is pushed toward the land portion 20 of the device substrate 12 and, therefore, an electrical connection can be attained therebetween. Simultaneously, the device substrate 12 can be rigidly connected to the terminal substrate 26. A thermo-setting anisotropic conductive adhesive film or paste, JPN8901, JPN8902, or JPN8903, made by Dupont Corp., can be used for this purpose.

Other aspects of this invention are defined in the following clauses:
(1) A semiconductor device comprising:
   a plate like device substrate having first and second surfaces;
   a semiconductor chip rigidly mounted on said first surface of said device substrate;
   circuit patterns formed on at least one of said first and second surfaces of said device substrate, each of said circuit pattern having one end which is electrically connected to said semiconductor chip and the other end formed as a land portion for electrically connecting to an outside circuit; and
   a moulded resin hermetically sealing said semi-conductor chip and at least each said one end of said circuit patterns.
(2) A mounting carrier for a semiconductor device, said mounting carrier comprising:
   a plate like terminal substrate having first and second surfaces and a plurality of through holes extending from said first surface to the second surface; and
   a plurality of mounting terminals inserted into and fixed to said respective through holes, each of said mounting terminals having first and second contacts projecting from said first and second surfaces of said terminal substrate, respectively.

## Claims

1. A semiconductor device comprising:
a plate like device substrate (12) having first and second surfaces;
a semiconductor chip (14) rigidly mounted on said first surface of said device substrate (12);
circuit patterns (16) formed on at least one of said first and second surfaces of said device substrate (12), each of said circuit patterns (16) having one end which is electrically connected to said semiconductor chip (14) and the other end formed as a land portion (20) for electrically connecting to an outside circuit;
a moulded resin (22) hermetically sealing said semi-conductor chip (14) and said each one end of said circuit patterns (16);
a plate like terminal substrate (26) having first and second surfaces and a plurality of through holes (30) extending from said first surface to the second surface;
a plurality of mounting terminals (32) inserted into and fixed to said respective through holes (30), each of said mounting terminals (32) having first and second contacts (34, 36) projecting from said first and second surfaces of said terminal substrate (26), respectively; and,
said terminal substrate (26) being attached to said device substrate (12), so that said first contacts (34) of said terminal substrate are electrically connected to said land portions (20) of said circuit patterns (16) of said device substrate (12).

2. A semiconductor device according to claim 1, wherein said circuit patterns (16) are formed on said first surface of said device substrate (12) on which a semiconductor chip (14) is mounted and said land portions (20) are arranged on a peripheral area of said first surface around said mould resin (22).

3. A semiconductor device according to claim 2, wherein said terminal substrate (26) has an opening (28) in which said moulded resin (22) is received and said second contacts (36) of said mounting terminals (32) extend away from said terminal substrate beyond said moulded resin.

4. A semiconductor device according to claim 1, wherein said circuit patterns (16) extend from said first surface to said second surface of said device substrate (12a) via through holes (52) and said land portions (20) are arranged on said second surface on which no semiconductor chip is mounted.

5. A semiconductor device according to claim 1, wherein said device substrate (12b) is a multi-layer substrate having a cavity in which the semiconductor chip (14) is located and which is filled with said moulded resin (22) and said land portions (20) are arranged on a peripheral area of said first surface around said cavity.

6. A semiconductor device according to any one of the preceding claims, wherein a metal sleeve (40) is inserted into each of said through holes (30) of said terminal substrate (26) or each of said through holes (30) of said terminal substrate is plated with a metal layer (50), such as a copper, and said respective mounting terminal (32) is inserted into said sleeve (40) or plated layer (50) in said through hole (30).

7. A semiconductor device according to any one of the preceding claims, wherein each of said mounting terminals (32) comprises a cylindrical portion (32) and a head portion (34) integrally connected to said cylindrical portion (32).

8. A semiconductor device according to claim 7, wherein a part (44) of said cylindrical portion (32) of said mounting terminal is enlarged in diameter thereof, so that said enlarged portion (44) is forcedly inserted into said through hole (30) of said terminal substrate (26).

9. A semiconductor device according to any one of the preceding claims, wherein said first contacts (34) of said terminal substrate (26) are electrically connected to said land portions (20) of said circuit patterns (16) of said device substrate (12) by soldering (42) or by an anisotropic conductive film or paste (46) disposed between said terminal substrate (26) and said device substrate (12).

10. A semiconductor device according to any one of claims 1 to 8, wherein said terminal substrate (26) is attached to said device substrate (12) by an adhesive agent (44).
